# EUROPÄISCHE PATENTSCHRIFT

(11) **EP 0 517 724 B1**
(45) Veröffentlichungstag und Bekanntmachung des Hinweises auf die Patenterteilung: **14.12.1994**
(21) Anmeldenummer: 91904075.8
(22) Anmeldetag: 21.02.1991
(51) Int. Cl.: C23C 16/40, C23C 16/44

(54) **VORRICHTUNG ZUM HERSTELLEN VON METALLMISCHOXIDSCHICHTEN**
DEVICE FOR PRODUCING FILMS OF MIXED METAL OXIDES
DISPOSITIF POUR LA PREPARATION DE COUCHES FORMEES D'OXYDES MIXTES METALLIQUES

(30) Priorität: 02.03.1990 DE 4006489
(43) Veröffentlichungstag der Anmeldung: 16.12.1992
(73) Patentinhaber: HOECHST AKTIENGESELLSCHAFT, 65926 Frankfurt am Main (DE)
(72) Erfinder: SCHLOSSER, Ernst-Günther, D-6233 Kelkheim (DE)
(86) Internationale Anmeldenummer: EP9100325
(87) Internationale Veröffentlichungsnummer: WO9113185

(56) Entgegenhaltungen:
- WO-A-89/07666
- DE-A- 3 827 069

## Beschreibung

Die Erfindung betrifft eine Vorrichtung zum Herstellen dünner Schichten aus Metallmischoxiden aus organischen Metallverbindungen auf einem Substrat.

Die modernen Hochtemperatur-Supraleiter (HTSL) aus Gemischen aus drei und mehr Metalloxiden haben wegen ihrer hohen Sprungtemperatur großes Interesse gefunden. Besondere Bedeutung kommt den HTSL zu, die als dünne Schichten relativ großflächig auf Trägersubstanzen (Substrate) angeordnet sind. Solche Schichten können durch Vakuum-Verdampfung, mittels Sputterverfahren, Laserablation, Spin- bzw. Spraycoating oder dem sogenannten Chemical Vapor Deposition (CVD)-Verfahren auf geeigneten Substraten abgeschieden werden. Insbesondere nach dem CVD-Verfahren lassen sich HTSL-Schichten hoher Qualität herstellen. Bei Verwendung schmaler Substrate wie Drähte und Fäden findet auch eine seitliche und rückwärtige Beschichtung statt.

Zur Durchführung des Chemical Vapor Deposition-Verfahrens ist bei der am 12. bis 13. Juni 1989 in Tokyo veranstalteten International Superconductivity Electronics Conference (ISEC' 89) [Extended Abstracts of 1989 International Superconductivity Electronics Confernce (ISEC '89) Seiten 425 - 428] eine evakuierbare Vorrichtung bekannt geworden, die aus drei Verdampfern besteht, die über eine Sammelleitung mit einer beheizbaren Aufnahmeeinrichtung für das Substrat in Verbindung stehen. Die organischen Metallverbindungen wie z.B. β-Diketon-Metallchelate des Yttriums, Bariums und Kupfers werden in den Verdampfern jeweils unterschiedlich stark erhitzt und der entstehende Dampf dieser Metallverbindungen mit Argon als Trägergas mit einem Sauerstoffstrom vereinigt und bei ca. 850°C pyrolisiert bzw. oxidiert und die entstehenden Metallmischoxide auf dem Substrat abgeschieden. Nachteilig bei dieser Vorrichtung ist der Aufwand an Regeltechnik für die Transportgasströme und die Heizeinrichtungen, die für die Rohrleitungen zwischen den Verdampfern und der Aufnahmeeinrichtung notwendig sind, um dort die Kondensation der Metallverbindungen zu vermeiden bzw. verfrüht einen Pyrolyse-Vorgang auszulösen. Infolge der Verdünnung durch das Transportgas ist der Stoffeinsatz hoch bei einer Abscheidungsrate von maximal 17 nm pro Minute. Außerdem zersetzt sich ein beträchtlicher Teil der Metallverbindungen vorzeitig wegen der langen Transportwege.

Hier will die Erfindung Abhilfe schaffen. Die Aufgabe wird durch eine Vorrichtung gelöst, bei der sich in einem evakuierbaren Gehäuse ein pyramidenstumpfförmiger Hohlkörper befindet, bei dem
1. konzentrisch zu seiner Symmetrieachse angeordnet sind
   a) im Boden des Hohlkörpers mindestens drei Öfen, die Aufnahmeeinrichtungen für die zu verdampfenden Metallverbindungen aufweisen, die mit Leitrohren versehen sind, die in den Hohlraum des Hohlkörpers ragen und gegen die Symmetrieachse geneigt sind,
   b) ein Rohr, in das der Mantel des Pyramidenstumpfes übergeht und über dessen Ende eine beheizbare Aufnahmeeinrichtung für das Substrat angeordnet ist und
2. in dessen Hohlraum zwischen den Leitrohren und dem Rohrende eine Gaszuführung endet.

Die Öfen können darüber hinaus symmetrisch um die Symmetrieachse des Hohlkörpers angeordnet sein. Zwischen dem Hohlkörper und der beheizbaren Aufnahmeeinrichtung für das Substrat kann eine Blende angeordnet sein. Als Gaszuführung können statt einer Einzeldüse auch mehrere Düsen oder ein Düsenring verwendet werden. Der Hohlkörper und das Rohr können mit einer Einrichtung zum Temperieren, d.h. zum Heizen und/oder Kühlen versehen sein. Zwecks thermischer Entkopplung können zwischen den Leitrohren Leitbleche angeordnet sein.

Die durch die Erfindung erreichten Vorteile sind im wesentlichen im Wegfall des Transportgases und dem damit verbundenen einfachen, kompakten Aufbau der Vorrichtung zu sehen. Ferner entfallen die Stoffverluste, die bei der bekannten Vorrichtung wegen der starken Verdünnung der Dämpfe durch das Trägergas entstehen. Durch den Wegfall langer Rohrleitungen wird vorzeitige Pyrolyse der Metallverbindungen vermieden. Es werden Abscheidungsraten von 130 nm und mehr pro Minute erreicht.

Im folgenden wird die Erfindung anhand von lediglich einer einen Ausführungsweg darstellenden Zeichnung näher erläutert.

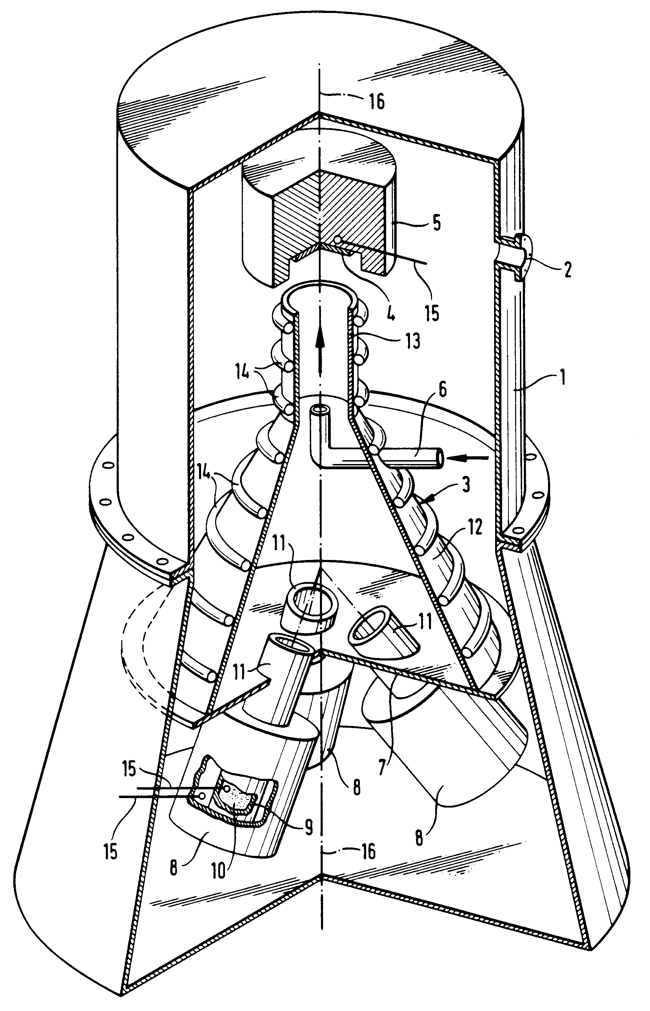

Es zeigt die Figur die Vorrichtung perspektivisch teilweise geschnitten.

In einem über Stutzen 2 evakuierbaren Gehäuse 1 ist ein pyramidenstumpfförmiger Hohlkörper 3 angeordnet. Als pyramidenstumpfförmiger Hohlkörper kommen 3 bis n-seitige Hohlkörper einschließlich kegelstumpfförmiger Hohlkörper in Betracht. Im Boden 7 des Hohlkörpers 3 sind konzentrisch zu seiner Symmetrieachse 16 mindestens drei Öfen 8 angeordnet. Zur Herstellung eines HTSL aus Mischoxiden mit mehr als drei Metallen ist die Anzahl der Öfen 8 entsprechend zu erhöhen.

In den Öfen 8 sind Aufnahmeeinrichtungen 9 für die zu verdampfenden organischen Metallverbindungen 10 angeordnet. Diese Aufnahmeeinrichtungen 9 sind mit Leitrohren 11 versehen, die durch den Boden 7 in den Hohlraum des Hohlkörpers 3 ragen und gegen die Symmetrieachse 16 geneigt sind. Durch die Neigung der Leitrohre 11 gegen die Symmetrieachse überlappen sich die aus den Leitrohren 11 austretenden Dampfwolken der organischen Metallverbindungen und durchmischen sich. Die Fokussierung und Durchmischung der Dampfwolken wird durch die konische Form des Hohlkörpermantels 12 unterstützt. Der Mantel 12 geht in ein Rohr 13 über, das ebenfalls konsentrisch zur Symmetrieachse 16 angeordnet ist und über dessen Ende sich eine beheizbare Aufnahmeeinrichtung 5 für das Substrat 4 befindet. Im Hohlraum des Hohlkörpers 3 mündet zwischen den Leitrohren 11 und dem Rohr 13 eine Gaszuführung 6 ein, für den für die Oxidation erforderlichen Sauerstoff. Um während der Anfahrphase das Substrat zu schützen kann zwischen Rohr 13 und Substrat 4 eine Blende (nicht dargestellt) angeordnet sein. Zwischen den Leitrohren 11 können Leitbleche (nicht dargestellt) angeordnet sein, sofern ein Temperaturausgleich zwischen den auf unterschiedlicher Temperatur befindlichen Öfen vermieden werden muß. Hohlkörper 3 und Rohr 13 können mit einer Einrichtung 14 versehen sein, die dem Heizen und/oder Kühlen dient. Sowohl die Öfen 8 als auch die Aufnahmeeinrichtungen 9 sind mit Temperaturfühlern 15 versehen, ebenso die Aufnahmeeinrichtung 5 für das Substrat 4.

## Patentansprüche

1. Vorrichtung zum Herstellen dünner Schichten aus Metallmischoxiden aus organischen Metallverbindungen auf einem Substrat, dadurch gekennzeichnet, daß sich in einem evakuierbaren Gehäuse (1) ein pyramidenstumpfförmiger Hohlkörper (3) befindet, bei dem
1. konzentrisch zu seiner Symmetrieachse (16) angeordnet sind
a) im Boden (7) des Hohlkörpers mindestens drei Öfen (8), die Aufnahmeeinrichtungen (9) für die zu verdampfenden Metallverbindungen (10) aufweisen, die mit Leitrohren (11) versehen sind, die in den Hohlraum des Hohlkörpers (3) ragen und gegen die Symmetrieachse (16) geneigt sind,
b) ein Rohr (13), in das der Mantel (12) des Pyramidenstumpfes übergeht und über dessen Ende eine beheizbare Aufnahmeeinrichtung (5) für das Substrat (4) angeordnet ist und
2. in dessen Hohlraum zwischen den Leitrohren (11) und dem Rohrende (13) eine Gaszuführung (6) endet.

2. Vorrichtung nach Anspruch 1, dadurch gekennzeichnet, daß die Öfen (8) konzentrisch und symmetrisch zur Symmetrieachse (16) des Hohlkörpers (3) angeordnet sind.

3. Vorrichtung nach einem der Ansprüche 1 oder 2, dadurch gekennzeichnet, daß zwischen Hohlkörper (3) und der beheizten Aufnahmeeinrichtung (5) für das Substrat (4) eine Blende angeordnet ist.

4. Vorrichtung nach einem der Ansprüche 1 bis 3, dadurch gekennzeichnet, daß die Gaszuführung (6) aus einem Düsenring besteht.

5. Vorrichtung nach einem der Ansprüche 1 bis 4, dadurch gekennzeichnet, daß der Hohlkörper (3) und das Rohr (13) mit einer Einrichtung (14) zum Temperieren versehen sind.

6. Vorrichtung nach einem der Ansprüche 1 bis 5, dadurch gekennzeichnet, daß zwischen den Leitrohren (11) Leitbleche angeordnet sind.

## Claims

1. Device for producing thin films of mixed metal oxides from organic metal compounds on a substrate, characterized in that there is, in an evacuable housing (1), a truncated-pyramidal hollow body (3)
1. in which there are disposed, concentrically with its axis of symmetry (16),
a) at least three furnaces (8) in the base (7) of the hollow body which have reception devices (9) for the metal compounds (10) to be evaporated, which reception devices (9) are provided with guide pipes (11) which project into the hollow interior of the hollow body (3) and are inclined towards the axis of symmetry (16),
b) a pipe (13) into which the casing (12) of the truncated pyramid merges and above whose end there is disposed a heatable reception device (5) for the substrate (4), and
2. in whose hollow interior a gas feed pipe (6) terminates between the guide pipes (11) and the end of the pipe (13).

2. Device according to Claim 1, characterized in that the furnaces (8) are disposed concentrically and symmetrically with respect to the axis of symmetry (16) of the hollow body (3).

3. Device according to one of Claims 1 or 2, characterized in that a shutter is disposed between hollow body (3) and the heated reception device (5) for the substrate (4).

4. Device according to one of Claims 1 to 3, characterized in that the gas feed pipe (6) comprises a nozzle ring.

5. Device according to one of Claims 1 to 4, characterized in that the hollow body (3) and the pipe (13) are provided with a temperature-control device (14).

6. Device according to one of Claims 1 to 5, characterized in that baffle plates are disposed between the guide pipes (11).

## Revendications

1. Dispositif pour la préparation de couches minces formées d'oxydes mixtes métalliques à partir de liaisons métalliques sur un substrat, caractérisé en ce qu'il se trouve, dans un boîtier où l'on peut faire le vide, un organe creux (3) ayant la forme d'un tronc de pyramide, dans lequel
1. sont disposés de façon concentrique par rapport à son axe de symétrie (16),
a) sur le fond (7) de l'organe creux, au moins trois fours (8) qui présentent des dispositifs de réception (9) pour les liaisons métalliques à faire évaporer, qui sont munis de tubes conducteurs, qui s'élèvent dans la cavité de l'organe creux et sont inclinés par rapport à l'axe de symétrie,
b) un tube (13), dans lequel passe le manteau 12 du tronc de la pyramide et au-dessus de l'extrémité duquel est placé un dispositif de réception (5), pouvant être chauffé, pour le substrat et
2. dans la cavité duquel se termine une arrivée de gaz, entre les tubes conducteurs et l'extrémité du tube.

2. Dispositif selon la revendication 1, caractérisé en ce que les fours (8) sont disposés de façon concentrique et symétrique par rapport à l'axe de symétrie (16) de l'organe creux (3).

3. Dispositif selon une des revendications 1 ou 2, caractérisé en ce qu'un écran est placé entre l'organe creux (3) et le dispositif chauffé de réception (5) pour le substrat (4).

4. Dispositif selon une des revendications 1 à 3, caractérisé en ce que l'arrivée de gaz (6) comprend une couronne de buses.

5. Dispositif selon une des revendications 1 à 4, caractérisé en ce que l'organe creux (3) et le tube (13) sont munis d'un dispositif (14) d'équilibrage de température.

6. Dispositif selon une des revendications 1 à 5, caractérisé en ce que des tôles conductrices sont placées entre les tubes conducteurs (11).
